# EUROPÄISCHE PATENTSCHRIFT

(11) **EP 2 802 069 B1**
(45) Veröffentlichungstag und Bekanntmachung des Hinweises auf die Patenterteilung: **30.11.2016**
(21) Anmeldenummer: 13401050.3
(22) Anmeldetag: 08.05.2013
(51) Int. Cl.: H02N 2/18, H01L 41/20, H01L 41/12

(54) **Nichtresonanter thermomechanischer Energiewandler**
Non-resonant thermo-mechanical energy converter
Convertisseur d'énergie thermomécanique non résonant

(43) Veröffentlichungstag der Anmeldung: 12.11.2014
(73) Patentinhaber: Karlsruher Institut für Technologie, 76131 Karlsruhe (DE)
(72) Erfinder: Kohl, Dr. Manfred, 76297 Stutensee (DE); Krevet, Dr. Berthold, 76706 Dettenheim (DE)

(56) Entgegenhaltungen:
- US-A1- 2009 315 335
- KOHL ET AL: "A ferromagnetic shape memory actuator designed for large 2D optical scanning", SENSORS AND ACTUATORS A, ELSEVIER SEQUOIA S.A., LAUSANNE, CH, Bd. 135, Nr. 1, 28. März 2007 (2007-03-28) , Seiten 92-98, XP005928251, ISSN: 0924-4247, DOI: 10.1016/J.SNA.2006.08.014

## Beschreibung

Die Erfindung betrifft einen nichtresonanten thermomechanischen Energiewandler gemäß des ersten Patentanspruchs.

Die Erfindung dient insbesondere der Energieversorgung von energieautarken Mikrosystemen. Herkömmliche Mikrosysteme werden üblicherweise durch externe Quellen elektrisch mit Energie versorgt. Dies erfolgt entweder drahtgebunden oder es werden Energiespeicher (Batterien, Akkumulatoren) eingesetzt. Anwendungen, bei denen eine kabelgebundene elektrische Energieversorgung oder ein notwendiger Wechsel von Energiespeichern nicht möglich oder erwünscht ist, erfordern alternative autarke Konzepte. Diese Konzepte sollen das Mikrosystem in die Lage versetzen, die für den Betrieb erforderliche Energie aus der direkten Umgebung zu beziehen und dabei ohne die üblichen (separaten) Energiequellen wie Batterien, Akkumulatoren oder einen drahtgebundenen elektrischen Anschluss zu einer externen Energieversorgung auskommt. Es wird also ein von diesen üblicherweise verwendeten Energiequellen unabhängiges, d.h. einen von diesen Energiequellen autarkes Konzept vorgeschlagen, das seine Energie aus der Umgebung generiert.

Mögliche Anwendungsfelder für autarke Mikrosysteme sind elektronische Systeme und Sensorprodukte zur Umgebungsüberwachung oder zur Überwachung mobiler Systeme. Bekannte Systeme wie z.B. in **[1]** beschrieben, nutzen hierzu mechanische Energie aus vorhandenen mechanischen Vibrationen der Umgebung. Aufgrund des oftmals resonanten Verhaltens der hierzu verwandten Energiewandler sprechen diese je nach Auslegung nur bei bestimmten Schwingungen, d.h. insbesondere bei Resonanzfrequenz oder einem Vielfachen dieser an. Durch Verwendung mehrerer baugleicher Wandler mit leicht unterschiedlicher Resonanz könnte ein gewisser Bandbreitenbereich abgedeckt werden. Nachteilig hierbei sind insbesondere die geringeren spezifischen Leistungsdaten und damit der erhöhte Platzbedarf dieser redundanten Systeme.

Ein Beispiel für den Stand der Technik findet sich in Patentschrift US2009/315335. Davon ausgehend liegt die **Aufgabe der Erfindung** darin, einen breitbandigen Energiewandler vorzuschlagen, der die vorgenannten Nachteile und Einschränkungen nicht aufweist und insbesondere den Anforderungen für die Versorgung von Mikrosystemen entgegenkommt. Dabei ist es eine Aufgabe der Erfindung, eine Energiequelle bevorzugt für ein Mikrosystem vorzuschlagen, die thermische Energie aus der Umgebung in elektrische Energie umwandelt.

Die Aufgabe wird mit einem nichtresonanten thermomechanischen Energiewandler mit den Merkmalen von Anspruch 1 gelöst. Auf diesen rückbezogene Unteransprüche geben vorteilhafte Ausführungen wieder.

Die Lösung der Aufgabe basiert auf einer Wandlung einer thermischen Energie in eine mechanische Bewegung über eine Ausnutzung von Phasenumwandlungen einer Formgedächtnislegierung, wobei im Rahmen der Erfindung sowohl ein Wechsel eines paramagnetischen und eines ferromagnetischen Zustands als auch der Formgedächtniseffekt für die abwechselnde Einstellung von zwei Schaltstellungen genutzt wird. Wesentlich dabei ist das Zusammenwirken eines magnetischen Effekts und eines Formgedächtniseffekts, wobei je einer dieser Effekte je eine der beiden Schaltstellungen aktiv anstrebt und der jeweils andere Effekt dabei deaktiviert ist. Die Lösung umfasst folglich ein Wechselspiel zwischen dem Formgedächtniseffekt und magnetischen Eigenschaften, bei dem wechselseitig stets ein Effekt aktiviert und ein Effekt deaktiviert ist. Die Lösung umfasst auch Ausführungen mit jeweils zwei gekoppelten gegenläufig angeordneten und wirkenden Aktoren, wobei jeweils eine der beiden Schaltstellungen eines ersten Aktors der jeweils anderen Schaltstellung eines gegenläufig wirkenden Aktors gegenüberstehen.

Als Ausführung der Lösung wird ein nichtresonanter thermomechanischer Energiewandler vorgeschlagen, vorzugsweise als Biegewandler oder Torsionswandler. Dieser umfasst ein Stellglied aus einer Formgedächtnislegierung, vorzugsweise einer magnetischen Formgedächtnislegierung, und ein auf dieses befestigtes weich- oder hartmagnetisches Stellelement. Die magnetische Formgedächtnislegierung weist eine Curie-Temperatur und eine Umwandlungstemperatur auf. Bei Über- und Unterschreiten der Curie-Temperatur wird eine Änderung der magnetischen Eigenschaften von ferro- zu paramagnetisch hervorgerufen. Grundsätzlich davon unabhängig erfolgt bei der Umwandlungstemperatur eine Phasenänderung von einer martensitischen zu einer austenitischen Phase und umgekehrt, die zur Einstellung einer vorgeprägten Gedächtnisstruktur bei Überschreitung der Umwandlungstemperatur nutzbar ist. Die bevorzugten magnetischen Formgedächtnislegierungen sind Ni-Mn-Ga- und Fe-Pd-Legierungen. Der besondere Vorteil von Ni-Mn-Ga-Legierungen, insbesondere in der Zusammensetzung 50 - 54 At% Ni, 23 - 25 At% Mn und 21 - 25 At% Ga für die Lösung der Aufgabe ist, dass die Curie-Temperatur und eine Umwandlungstemperatur nahe beieinander liegen und somit Änderungen der Form und der magnetischen Eigenschaften in einem bevorzugt kleinen Temperaturfenster stattfinden. Vorzugsweise umfasst der Energiewandler Biegebalken als Stellglied.

Bei Überschreitung der Curie-Temperatur wandeln sich die magnetischen Eigenschaften von einem ferromagnetischen in einen paramagnetischen Zustand um. Dabei kommt es bei Überschreitung auch der Umwandlungstemperatur zu einer Phasenumwandlung und damit zu einer Formänderung im Stellglied (Formgedächtniseffekt). Die Dynamik der Bewegung wird durch die Aufheiz- bzw. Abkühlungsgeschwindigkeit beeinflusst, die durch die Temperaturunterschiede zwischen Umwandlungstemperatur und Umgebungstemperatur einerseits und zwischen Curie-Temperatur und Umgebungstemperatur andererseits bestimmt sind. Durch Überschreiten der Curie-Temperatur wird die magnetische Rückstellkraft ausgeschaltet, wodurch besonders große Stellwege realisierbar werden.

Für eine Formgedächtnislegierung ist eine Umwandlungstemperatur charakteristisch, bei der sich bei einem Überschreiten dieser eine martensitische Modifikation in eine austenitische Modifikation umwandelt und nur in dieser Modifikation eine eingeprägte Gedächtnisgestalt annimmt (Einweg-Effekt). Im Gegensatz zur der austenitischen Modifikation tritt beim Einweg-Effekt in der martensitischen Modifikation somit keine vorab eingeprägte Gedächtnisgestalt auf. Der Einweg-Effekt lässt sich im Bereich der Erfindung allein dadurch nutzen, dass durch zyklisches Durchfahren der Umwandlungstemperatur ein Biege- oder Torsionselement als Stellglied zwischen zwei Positionen, welche durch die eingeprägte Gedächtnisgestalt und die Gestalt des Stellglieds in der martensitischen Modifikation gegeben sind, hin- und hergeschaltet wird.

Eine weitere Möglichkeit besteht in der Nutzung eines sog. Zweiweg-Effekts, bei dem auch in der martensitischen Modifikation eine Gedächtnisgestalt vorliegt. Er stellt somit ein Sonderfall des Einweg-Effekts dar.

Die martensitische Phase tritt unterhalb der Umwandlungstemperaturen auf. Sofern diese Phase - wie z.B. im Falle einer bevorzugten NiMnGa-Legierung - ferromagnetische Eigenschaften aufweist, liegt eine Ausführung im Rahmen der Erfindung vor, bei der das Stellglied und das Stellelement durch ein einstückiges oder zusammengesetztes Stellelement mit ferromagnetischen Eigenschaften unterhalb der Umwandlungstemperatur gebildet werden.

Die austenitische Phase bildet sich oberhalb der Umwandlungstemperatur und weist - wie z.B. im Falle der bevorzugten NiMnGa-Legierung - keine magnetischen oder paramagnetischen Eigenschaften auf. Die Erwärmung in die austenitische Phase bewirkt jedoch eine Formänderung im Stellglied, wobei eine in das Stellglied voreingeprägte Form eingenommen wird, die von der in der martensitische Phase (aufgrund der magnetischen Kräfte) vorgegebenen Form abweicht.

Das Stellglied mit dem Stellelement wechselt durch Über- und Unterschreiten der jeweiligen Umwandlungstemperatur und der Curie-Temperatur zwischen zwei Schaltstellungen und weist entsprechende Mittel zum wiederkehrenden Wechsel zwischen diesen Schaltstellungen auf.

In einer ersten Schaltstellung unterhalb der Curie-Temperatur (und vorzugsweise auch der Umwandlungstemperatur) stellen sich im Stellglied vorzugsweise ferromagnetische Eigenschaften ein. Das weichmagnetische Stellelement und vorzugsweise auch das ferromagnetische Stellglied werden in dieser Stellung durch magnetische Mittel magnetisch ausgelenkt, vorzugsweise von einem Magneten angezogen und zu diesem ausgelenkt, wobei das Stellglied über diese Auslenkung an ein Heizelement gedrückt wird. Mit der Berührung liegt das Stellglied am Heizelement an, und es bildet sich eine thermische Verbindung zwischen der Formgedächtnislegierung und dem Heizelement, die eine Überschreitung der Umwandlungstemperatur bewirkt.

Mit der Überschreitung der Umwandlungstemperatur kommt es zu der vorgenannten Phasenänderung der Formgedächtnislegierung und der damit verbundenen vorab eingeprägten Formänderung im Stellglied. Die vorgegebene Formänderung bewirkt eine Stellbewegung des Stellglieds mit dem Stellelement entgegen der magnetischen Anziehungskraft der magnetischen Mittel in Richtung einer zweiten Schaltstellung. Die Stellbewegung wird durch eine thermische Trennung des Stellglieds von dem Heizelement eingeleitet, wobei eine weitere Erwärmung des Stellglieds vermieden wird. Es folgt ein Einschwenken des Stellglieds in die eingeprägte Gedächtnisgestalt, die zugleich die Position des Stellglieds in der zweiten Schaltstellung bestimmt.

Mit einem Hin- und Herschalten zwischen den beiden Schaltstellungen erfolgt auch ein Aus- und Einschalten oder eine Aktivierung und Deaktivierung von Energiegenerierungsmittel, d.h. Einrichtungen zur Generierung von Energie aus Umgebungseinflüssen (elektromagnetische und/oder elektrothermische Wandlung). Die Energie wird durch einen sich ändernden Einfluss dieser Umgebungseinflüsse auf das Stellelement und damit Komponenten dieser Einrichtungen zueinander erzeugt. Diese Komponenten umfassen vorzugsweise Induktionsspulen die von einem sich bewegenden Stellglied beeinflusst werden und/oder pyroelektrische Materialien vorzugsweise auf dem sich bewegenden Stellglied, die beim thermischen Kontakt mit dem vorzugsweise feststehenden Heizglied in einer Schaltstellung erwärmt werden und mit einer Temperaturänderung eine pyroelektrische Spannung erzeugen. Beide genannte Energiegenerierungsmittel sind in einem nichtresonanten thermomechanischer Energiewandler der eingangs genannten Art miteinander kombinierbar.

In der zweiten Schaltstellung befinden sich das Stellglied und vorzugsweise auch das Stellelement im Falle einer elektromagnetischen Wandlung im Feld, d.h. zwischen den Polen eines Elektromagneten mit einer Induktionsspule, während Stellglied und vorzugsweise auch das Stellelement außerhalb der zweiten Schaltstellung, vorzugsweise auch in der ersten Schaltstellung sich außerhalb des genannten Felds befinden.

Alternativ befinden sich das Stellglied und vorzugsweise auch das Stellelement auch in der ersten Schaltstellung und/oder auch zwischen den Schaltstellungen im Feld eines Elektromagneten mit einer Induktionsspule. Es sind also vorzugsweise eine, zwei oder mehrere elektrische Felder jeweils durch einen Elektromagneten mit einer oder mehreren Induktionsspulen vorgesehen, die vom Stellglied und/oder Stellelement durchfahrbar sind. Alternativ lassen sich auch mehrere getrennte Felder durch einen Elektromagneten mit zu den Magnetpolen hin unterteiltem oder verzweigendem Eisenkern realisieren. Wesentlich ist dabei, dass sich das Stellglied und/oder das Stellelement bei einer Bewegung wie z.B. einem Wechsel der Schaltstellung in das Feld einschwingt, durch das Feld durchschwingt oder im Feld eine Änderung der magnetischen Eigenschaften z.B. bei einem Phasenübergang bei einer Aufheizung/Abkühlung erfolgt.

In der zweiten Schaltstellung erfolgt mangels thermischen Festkörperkontakt zum Heizelement eine weitere Abkühlung des Stellglieds, die optional durch ein Kühlmittel (Anströmung, Spray, Phasenübergang etc.) oder ein Kühlelement (z.B. kaltes Element mit Festkörperkontakt) beschleunigbar ist. Bei Unterschreitung der Curie-Temperatur und der Umwandlungstemperatur verliert das Stellglied seine eingeprägte Gedächtnisgestalt (und seine paramagnetischen Eigenschaften). Das Stellglied nimmt seine ursprüngliche Form, die vorzugsweise der Form in erster Schaltstellung entspricht, wieder ein. Die Rückstellung in die erste Schaltstellung erfolgt aufgrund der magnetischen Mittel, die vorzugsweise auf das weichmagnetische Stellelement und/oder auf das unterhalb der Umwandlungstemperatur optional ferromagnetisches Stellglied einwirken.

Ein Wechsel zwischen erster und zweiter Schaltstellung bewirkt ein wiederkehrendes Ein- und Ausschwenken des Stellglieds und vorzugsweise auch des weichmagnetischen Stellelements in bzw. aus dem Feld oder den Feldern des oder der Elektromagneten mit der Induktionsspule. Dadurch wird ein geschlossener Bewegungszyklus ermöglicht. Die dabei erfolgten Feldänderungen bewirken dann eine Induktion in der elektrischen Spule des Elektromagneten oder der Induktionsspule und damit eine Generierung einer elektrischen Spannung. Der Bewegungsraum des Stellelements weist zwei Extrempositionen auf, die sich hinsichtlich der lokalen Umgebungstemperatur und ihrem Einfluss auf das vorgenannte Feld hinreichend stark unterscheiden. Die erste und zweite Schaltstellung ist dabei nicht zwingend auf je eine Position beschränkt. Vielmehr können je Schaltstellungen auch zwei oder mehrere gleichwirkende Positionen vorgesehen werden, die im Wechsel mit jeweils Positionen der jeweils anderen Schaltstellung stehen. Es ist ausschließlich eine Wärmequelle (Heizelement) erforderlich. Vorzugsweise kommt der Energiewandler für seinen Bewegungszyklus ohne elektrische Kontakte aus.

Der besondere Vorteil des beschriebenen elektromagnetischen Energiewandlers liegt in den hohen durch das Stellglied durch den Formgedächtniseffekt und der magnetischen Eigenschaften erzeugbaren Kräften zwischen erster und zweiter Schaltstellung. Mit den hohen Kräften gehen bei der Energiewandlung auch hohe mechanische und damit auch hohe erzeugbare elektromagnetische Energien einher.

Eine weitere Ausführung der elektromagnetischen Energiewandlung sieht eine Mikrospule (Induktionsspule) direkt auf dem Stellelement oder Stellglied vor, wobei die Mikrospule nicht ortsfest ist, sondern mit dem Stellelement relativ zu einem Magnetfeld, hervorgerufen durch vorzugsweise ortsfeste Dauermagnete, ausschwenkt. Vorzugsweise ist bei dieser Ausführungsform das Stellglied und/oder Stellelement zweiteilig (z.B. Doppelbalken) ausgebildet, wobei die Mikrospule beidseitig an je ein Teil angrenzt und kontaktiert ist.

Die beschriebene Alternative zur elektromagnetischen Energiegewinnung nutzt den pyroelektrischen Effekt pyroelektrischer Materialien, die bei einer Temperaturänderung eine über mindestens zwei Elektroden abgreifbare elektrische Spannung erzeugen. Diese Spannungen sind im Vergleich zu denen einer elektromagnetischen Induktion vergleichsweise hoch (vorzugsweise einige 10 mV wie 20, 30 oder 50 mV bis ca. 1 V), womit sie sich besonders für die Versorgung mikroelektronischer Systeme eignen. Spannungen sind erst ab einer Höhe von 10 mV auf bei mikroelektronischen Systemen benötigte 1 bis 3 V verstärkbar. Umso höher die Spannung ist, desto weniger Verluste entstehen bei der Verstärkung>. Vorzugsweise sind im Rahmen möglicher Ausführungen pyroelektrische Materialien als pyroelektrische Komponente auf dem verstellbaren und damit beweglichen Teil des Energiewandlers (Aktor, Stellglied, Stellelement) aufgebracht. Allein durch ein periodisches Hin- und Herschalten wird ein periodisch wiederkehrender direkter thermischer Kontakt zum Heizelement hergestellt. Die elektrische Kontaktierung erfolgt vorzugsweise über das Stellglied oder Stellelement.

Vorzugsweise ist das pyroelektrisches Material direkt am Stellelement, alternativ an das Stellglied angebracht, welches durch Erwärmen bzw. Abkühlen eine elektrische Spannung erzeugt, die zur Energiewandlung genutzt wird. Das pyrolelektrische Material ist damit thermisch mit dem Stellelement bzw. Stellglied gekoppelt und folgt damit auch dessen Temperaturschwankungen. Eine thermische Anbindung erfolgt entweder direkt mit dem Heizelement in einer Schaltstellung oder indirekt über das Stellelement und/oder das Stellglied. Vorzugsweise ist bei dieser Ausführungsform das Stellglied und/oder Stellelement zweiteilig (z.B. Doppelbalken) ausgebildet, wobei das pyroelelektrische Material beidseitig an je ein Teil angrenzt und kontaktiert ist.

Vorteilhaft ist ein zusätzliches optionales Kühlelement, das nur in der zweiten Schaltstellung mit dem Stellelement, Stellglied und/oder dem pyrolelektrischen Material thermisch verbunden ist und beim Kontakt eine beschleunigte Abkühlung bewirkt. Vorzugsweise ist dieses Kühlelement (wie auch optional das Heizelement) nachgiebig und begünstigt durch einen besseren Kontakt eine verbesserte thermische Anbindung.

Die Erfindung nutzt die nicht-resonanten thermomagnetomechanischen Eigenschaften eines beweglichen Bauteils aus einer bevorzugt ferromagnetischen Formgedächtnislegierung oder einer Verbundschicht aus Formgedächtnislegierung und magnetischer Schicht (z.B. Bimetallstreifen oder Multischichtanordung). Das Bauteil ist vorzugsweise als Biegebalken, Torsionselement oder Brücke ausgeführt.

Das Stellglied umfasst vorzugsweise einen Blechstreifen (Balken) mit zwei Enden, der in der ersten Schaltstellung flächig auf dem Heizelement anliegt. Dabei erwärmt sich das Stellglied auf eine Temperatur oberhalb der Umwandlungstemperatur, wodurch der Blechstreifen die ihm vorgegebene Form einnimmt und dabei den thermischen Kontakt zum Heizelement unterbricht.

Eine erste Ausführungsform sieht einen Balken (vorzugsweise Blechstreifen) als einarmiges Stellglied vor, der an einem Ende fest eingespannt ist und an dem anderen Ende das Stellelement befestigt ist (Cantilever-Bauform).

Eine zweite Ausführungsform sieht einen Blechstreifen als symmetrisches Stellglied vor, der an beiden Enden eingespannt ist und das Stellelement an mittig zwischen den beiden Enden auf dem Blechstreifen befestigt ist.

Beide vorgenannten Ausführungsformen können in jeweils einer Abwandlung mit zwei oder mehreren gleichen gekoppelten und / oder parallel zueinander angeordneten und wirkenden Stellglieder ausgestaltet sein.

Eine weitere Ausführung sieht ein Torsionselement, vorzugsweise in der Form zweier kreuzenden Balken, realisiert z.B. durch zwei sich kreuzende Blechstreifen oder einem kreuzförmig ausgeschnittenen Blech als Stellglied vor. Es ist vorzugsweise an den beiden Enden eines Balkens, dem Torsionselement eingespannt und wird im Bereich des anderen kreuzenden Balkens unter Bildung von Drehmomenthebeln tordierend ausgelenkt. Der Formgedächtniseffekt greift je nach Ausführung an den Drehmomenthebeln oder den Torsionselementen an.

Eine weitere Ausführung sieht zumindest zwei parallel angeordnete, gekoppelte, aber gegenläufig wirkende Stellglieder vor. Diese Ausführung eignet sich in besonderem Maße auch für eine ggf. erforderliche Kontaktierung von Komponenten (z.B. pyroelektrisches Material oder Mikrospule) auf dem Stellelement oder Stellglied. Im Betrieb nehmen die Stellglieder jeweils unterschiedliche Schaltstellungen ein, d.h. sie schalten gegenläufig. In beiden Schaltstellungen befindet sich je ein Schaltelement in erster und in zweiter Schaltstellung. In diesem Fall muss nicht jede zweite Schaltstellung eine Position im Feld eines Elektromagneten mit Induktionsspule in vorgenannter Weise einnehmen. Darüber hinaus sind keine magnetischen Mittel zum stabilen Halten der Schaltstellungen erforderlich.

Bei einer Anwendung zur Energieversorgung speziell von elektronischen oder elektromechanischen Mikrosystemen ist der Energiewandler vorzugsweise in der Schaltungsarchitektur z.B. auf der Platine integriert. Als Heizelement lassen sich optional und vorteilhafter Weise elektronische Bauteile verwenden (direkter Kontakt oder über thermische Übertragungselemente), die sich im Betrieb auf eine Betriebstemperatur oberhalb der Aufheiz-Umwandlungstemperatur erwärmen.

Da der vorgeschlagene Bewegungsmechanismus auf der thermischen Formgedächtniskraft in einem Temperaturgradienten und der magnetostatischen Anziehungskraft in einem Feldgradienten basiert, liegt hier eine nicht-resonante Anregung vor. Die Frequenz-Bandbreite wird ausschließlich von thermischen Zeitkonstanten der Wärmeübertragung bestimmt.

Durch das vorgeschlagene Prinzip des nichtresonanten thermomechanischen Energiewandlers ist in vorteilhafter Weise eine nicht-resonante Bewegungserzeugung erzielbar, wobei zum Betrieb energieautarker Mikrosysteme mit elektrischer Energie allein eine Nutzung vorhandener Wärmequellen oder der Umgebungswärme möglich wird.

Die Erfindung umfasst auch einen nichtresonanten thermomechanischer Energiewandler dadurch gekennzeichnet, dass
- die Formgedächtnislegierung nur eine Umwandlungstemperatur und keine Curie-Temperatur aufweist, die zwischen den beiden Schaltstellungen durchfahren wird,
- das Stellglied ein magnetisches vorzugsweise weichmagnetisches Stellelement aufweist, das mit einem externen Permanentmagneten in Wechselwirkung steht und von diesem permanent angezogen wird,
- das vorgenannte Stellelement integraler Bestandteil des Stellglieds ist, vorzugsweise, dass das Stellelement eine Curie-Temperatur aufweist, die zwischen den beiden Schaltstellungen durchfahren wird, unterhalb derer das Stellelement magnetisch mit einem externen Permanentmagneten in Wechselwirkung steht und von diesem permanent angezogen wird, wobei optional das Heizelement als Permanentmagnet dient,
- das Stellglied aus einem Kreuz mit vier Enden besteht, wobei zwei gegenüberliegende Enden fest eingespannt und je ein Stellelement am Ende der freibeweglichen Enden des Kreuzes befestigt sind (Torsionselement vorzugsweise mit Torsionsbalken und Drehmomentbalken),
- die Mittel für einen wiederkehrenden Wechsel zwischen zwei Schaltstellungen des Stellglieds mit dem Stellelement durch zwei oder mehrere symmetrisch zur Symmetriebene des Stellglieds angeordnete Permanentmagnete und Heizelemente gebildet werden,
- zwei Streifen oder Balken an ihren jeweiligen Enden fest eingespannt sind und in ihrer Mitte durch ein Abstandselement, vorzugsweise durch ein Stellelement gegeneinander vorausgelenkt sind,
- die Streifen oder Balken bei gleicher Vorauslenkung eine symmetrische Schaltstellung einnehmen und bei selektiver Erwärmung durch ein Heizelement jeweils eine erste und zweite Schaltstellung oberhalb beziehungsweise unterhalb der Symmetrieebene der symmetrischen Schaltstellung einnehmen und/oder
- die vorgenannten Mittel durch zwei oder mehrere symmetrisch zur Symmetrieebene angeordnete Permanentmagnete und Heizelemente gebildet werden.

Die Erfindung wird im Folgenden anhand von Ausführungsformen des nichtresonanten thermomechanischen Energiewandlers und Figuren erläutert. Es zeigen
**Fig. 1a** **und b** eine erste Ausführungsform des nichtresonanten thermomechanischen Energiewandlers mit einarmigem Stellglied mit je einer ersten (**a**) und zweiten Schaltstellung (**b**),
**Fig.2a** **und b** eine zweite Ausführungsform mit einarmigem Stellglied mit zwei ersten (**a**) und einer zweiten Schaltstellungen (**b**),
**Fig.3a** **und b** eine dritte Ausführungsform mit zwei parallel angeordneten, gekoppelten sowie gegenläufig parallel wirkenden symmetrischen Stellgliedern in zwei Schaltstellungen sowie
**Fig.4** eine vierte Ausführungsform mit einem Torsionselement, auf das zwei Heizelemente, Permanentmagnete mit zwei Induktionsspulen wirken.

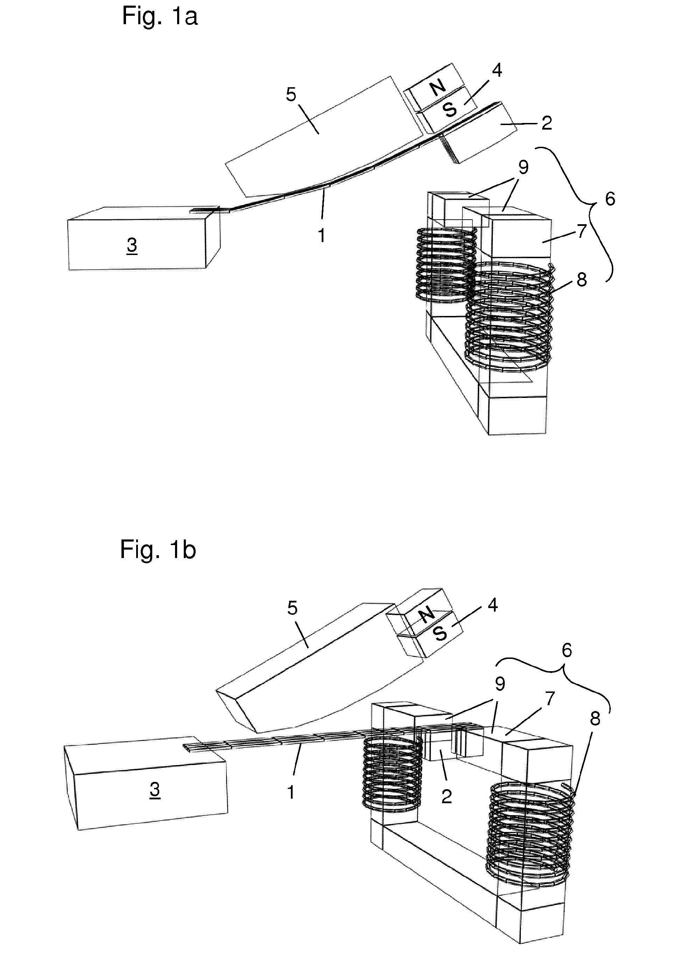

**Fig. 1a** **und b** zeigen als mögliche Ausführung einen Formgedächtnislegierung-Biegebalken **1** als Stellglied mit einem weichmagnetischem Vorderende **2** als Stellelement. Der Biegebalken ist an einem Ende in einer Einspannung **3** fixiert und ist mit dem anderen Ende mit dem Vorderende beweglich. Der Bewegungsraum des Bauteils weist zwei Schaltstellungen auf, die zugleich Extrempositionen eines zyklischen Bewegungsablaufs sind und die sich hinsichtlich der lokalen Umgebungstemperatur unterscheiden. Der Energiewandler umfasst ferner noch einen Permanentmagneten **4** als Gegenstück für das Vorderende **2**, ein Heizelement **5** als Gegenstück für den Biegebalken **1** jeweils in der ersten Schaltstellung sowie einen Elektromagneten **6** mit offenen Eisenkern **7** und Induktionsspulen (Pick-up-Spule) zur Erzeugung einer Induktionsspannung und einer Spule **8** zur Erzeugung eines magnetischen Feldes insbesondere zwischen den Polen **9** des offenen Eisenkerns, in dem das Vorderende in der zweiten Schaltstellung einragt.

In der ersten Schaltstellung (**Fig. 1a**) liegt die Temperatur des Biegebalkens **1** zunächst unterhalb der Curie-Temperatur, d.h. er weist sowohl ferromagnetische als auch martensitische Eigenschaften auf. Der Formgedächtniseffekt ist nicht aktiv, d.h. der Biegebalken nimmt nicht seine vorgeprägte Formgedächtnisgestalt ein. Das Stellelement (Vorderende) wird dadurch magnetisch an den Permanentmagneten **4** angezogen. Dabei legt sich der Biegebalken **1** (Stellglied) an das Heizelement an, wird bei Kontakt durch dieses auf eine Temperatur oberhalb der Umwandlungstemperatur aufgewärmt. Je nach Material kann dabei zusätzlich die Curie-Temperatur T_{c} überschritten werden. Durch den Formgedächtniseffekt und unterstützt durch Wegfall der magnetischen Anziehungskraft im Biegebalken oberhalb T_{c} wird der Biegebalken bei Überwindung der magnetischen Anziehungskräfte zwischen Vorderende und Permanentmagneten von dem Heizelement weggedrückt und nimmt die zweite Schaltstellung (**Fig. 1b**) ein. Dabei schwenkt das Stellelement in das Feld des Elektromagneten **6**. Schon mit der Unterbrechung des Wärmekontakts zwischen Biegebalken und Heizelement erfolgt eine Abkühlung des Biegebalkens durch die Umgebung. Dies führt zu einer Rückumwandlung der Formgedächtnislegierung und zum Unterschreiten von T_{c}. Dadurch wird eine Rückbewegung zum Heizelement ausgelöst und folglich ein geschlossener Bewegungszyklus ermöglicht. Die Bewegung des Weichmagneten relativ zum magnetischen Kreis der Pick-up-Spule bewirkt eine Spannungsinduktion.

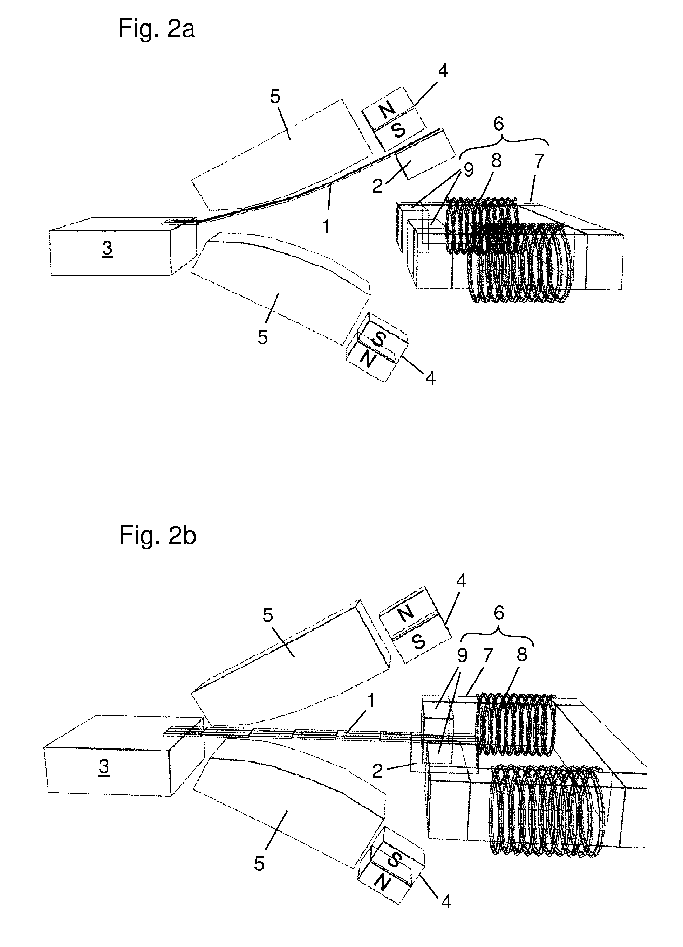

**Fig.2a** **und b** zeigen eine zweite Ausführungsform, die in ihren Grundelementen der vorgenannten ersten Ausführungsform ähnelt. Sie unterscheidet sich darin, dass zwei Permanentmagnete **4** und zwei Heizelemente **5** vorgesehen sind, die jeweils eine erste Schaltstellung vorgeben. Die beiden symmetrisch um das Biegeelement **1** angeordneten Heizelemente sorgen wie im vorgenannten Ausführungsbeispiel für die thermische Auslösung des Formgedächtniseffekts in beiden Extrempositionen, die durch die ersten Schaltstellungen vorgegeben sind. Miniaturmagnete zu beiden Seiten der Symmetrieebene sorgen für die magnetostatische Anziehungskraft im kalten Zustand. Der besondere Vorteil dieser zweiten Ausführungsform liegt darin, dass in der zweiten Schaltstellung keine Bewegungsumkehrung des Biegebalkens **1** und des Vorderendes **2** erforderlich ist, die mit der Umkehrung einhergehenden Massenträgheiten entfallen und damit schnellere Flussänderungen in der Pick-Up-Spule und damit höhere Spannungsänderungen möglich sind. Ferner werden der Formgedächtniseffekt und die magnetostatische Rückstellung in zwei Richtungen genutzt und der Stellweg verdoppelt.

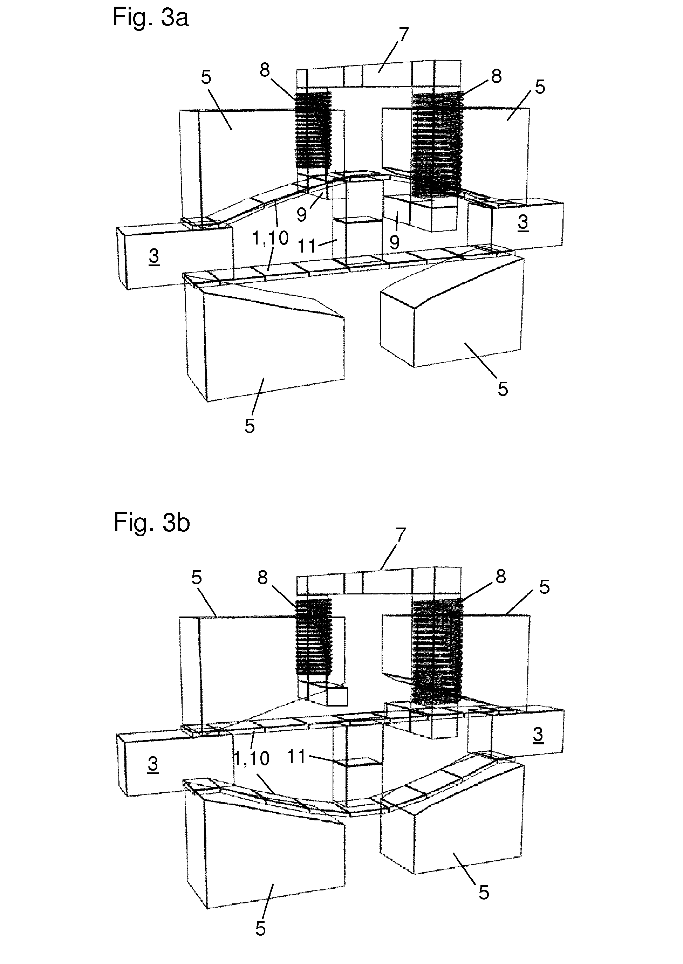

**Fig.3a** **und b** offenbaren beispielhaft eine Ausführungsform mit zwei beidseitig fixierten Biegebalken **1** (zwei Formgedächtnislegierung-Brücken **10**) die jeweils in der Mitte durch einen Permanentmagneten als Abstandselement **11** relativ zueinander vorgespannt sind. Symmetrisch angeordnete Heizelemente **5** sorgen für die Auslösung der Formgedächtniskraft in den beiden Extrempositionen. Beide Extrempositionen kennzeichnen sich dadurch, dass je eine Brücke sich in der ersten und zugleich eine in der zweiten Schaltposition befindet. Das Abstandselement **11** ragt dabei nur in einer, im Beispiel in der **Fig.3a** dargestellten Extremposition zwischen Pole **9** des offenen Eisenkerns **8** des Elektromagneten, während es in der anderen, im Beispiel in der **Fig.3b** dargestellten Extremposition außerhalb des offenen Eisenkerns weilt. Die bevorzugt zyklische Bewegung des Abstandselements aus und in den offenen Eisenkern des Elektromagneten relativ zum magnetischen Kreis der Pick-up-Spule bewirkt eine Spannungsinduktion.

**Fig.3a** **und b** offenbaren abweichend zu **Fig. 1** **und** **2** keine Permanentmagnete **4**. Die Stabilität der Extrempositionen ist allein durch die Formgedächtniseffekte der Biegebalken hinreichend gegeben.

Optional und in besonders vorteilhafter Weise werden jedoch zwischen den oberen bzw. unteren beiden Heizelementen Permanentmagnete vorgesehen, die beidseitig auf das optional magnetische Abstandselement und/oder jeweils eines der magnetischen Stellglieder (d.h. unterhalb der Curie-Temperatur) einwirken und die vorgenannten Extrempositionen weiter stabilisieren.

Bevorzugt weisen in dieser vorgenannten, aber auch in allen anderen Ausführungen nur die Stellglieder ferromagnetische Eigenschaften auf. Das Stellelement (z.B. Abstandselement oder Vorderende) ist dabei magnetisch. Die Curie-Temperatur liegt dabei bevorzugt zwischen den Temperaturen der beiden Schaltstellungen, d.h. sie wird bei Erwärmung des Stellglieds an den Heizelementen wie die Umwandlungstemperatur überschritten. In vorteilhafter Weise erfolgt die Umwandlung in die eingeprägte Formgedächtnisgestalt gemeinsam mit einer Aufhebung der ferromagnetischen Eigenschaft des Stellglieds.

Das Abstandselement **11** als Stellelement weist ferner optional magnetische Eigenschaften auf übernimmt dabei die Funktion der Vorderenden **2**. Alternativ hierzu lassen sich auch das Abstandselement als Permanentmagnet gestalten, während die beiden vorgenannten Permanentmagneten durch magnetische Gegenpole ersetzt werden. Wesentlich ist die magnetische Wechselwirkung zwischen einem Permanentmagneten und einem magnetischen Werkstoff.

Eine nicht explizit in Figuren dargestellte Variante der Ausführungsform in **Fig.3a** **und b** weist eine symmetrische Anordnung von zwei Elektromagneten auf. Ausgehend von der in **Fig.3a** dargestellten Ausführung ist ein zusätzlicher Elektromagnet vorgesehen. Die Pole des offenen Eisenkerns dieses zusätzlichen Elektromagneten sind unterhalb der Pole **9** des in **Fig.3a** **und b** dargestellten Elektromagneten angeordnet, und zwar in der Weise, dass die Pole nur in der in **Fig.3b** dargestellten Darstellung (untere Schaltstellung) beidseitig zum Abstandselements **11** angeordnet sind. In der in **Fig.3a** dargestellten Schaltstellung befindet sich das Abstandselement oberhalb der genannten Pole und damit des elektrischen Feldes. Das Ein- und Ausschwenken des Abstandshalters erfolgt wie in **Fig.3a** **und b** dargestellter Weise analog, jedoch in spiegelsymmetrisch umgekehrter Weise.

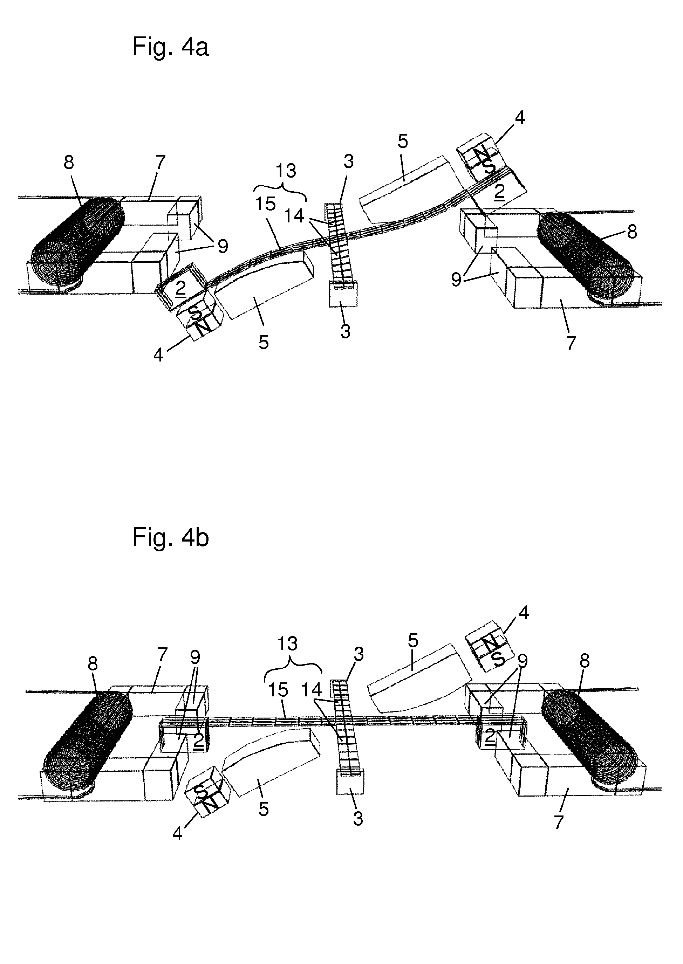

**Fig.4** zeigt eine vierte Ausführungsform beispielhaft mit einem Torsionselement **12** mit zwei sich kreuzenden Balken. Ein erster Balken bildet den Torsionsbalken **13**, der an beiden Enden in je einer Einspannung **3** fixiert ist. Die Torsion wird durch Drehmomenteinwirkung vorzugsweise mittig über den zweiten Balken, den Drehmomenthebel wirkenden Drehmomentbalken **15** mit zwei endseitig angebrachten Vorderenden **2** eingebracht. Heizelemente **5** und Permanentmangente **4** wirken symmetrisch zum Torsionsbalken auf beide Seiten des Drehmomentbalkens und die Vorderenden in der in **Fig. 1a** **und b** dargestellten Weise analog, wobei im Rahmen der dargestellten Ausführung der Biegebalken durch den Drehmomentbalken sowie die Einspannung durch den Torsionsbalken gebildet werden. Die erste Schaltstellung wird durch **Fig.4a**, die zweite Schaltstellung durch **Fig.4b** wiedergegeben.

### Literatur:

[1] S.P.Beeby, M.J.Tudor, N.M.White: Energy harvesting vibration sources for microsystems applications; Meas. Sci. Technol. 17 (2006) R175-R195

### Bezugszeichenliste:

- 1: Biegebalken
- 2: Vorderende
- 3: Einspannung
- 4: Permanentmagnet
- 5: Heizelement
- 6: Elektromagnet
- 7: Eisenkern
- 8: Induktionsspule
- 9: Pol
- 10: Brücke
- 11: Abstandselement
- 12: Torsionselement
- 13: Torsionsbalken
- 14: Drehmomentbalken

## Patentansprüche

1. Nichtresonanter thermomechanischer Energiewandler, **dadurch gekennzeichnet, dass**
a) ein Stellglied **(1)** aus einer Formgedächtnislegierung mit einem Stellelement **(2)** vorgesehen ist, wobei die Formgedächtnislegierung eine Curie-Temperatur und eine Umwandlungstemperatur von einer martensitischen zu einer austenitischen Phase aufweist,
b) Mittel für einen wiederkehrenden Wechsel zwischen zwei Schaltstellungen des Stellglieds vorgesehen sind, wobei
c) die Formgedächtnislegierung in einer ersten Schaltstellung unterhalb der Curie-Temperatur und der Umwandlungstemperatur sowohl ferromagnetische als auch martensitische Eigenschaften aufweist und das Stellglied mit einem Permanentmagneten **(4)** sowie mit einem Heizelement **(5)** nur in der ersten Schaltstellung eine magnetische bzw. thermische Wechselwirkung überwiegt,
d) die Formgedächtnislegierung in einer zweiten Schaltstellung oberhalb der Curie-Temperatur und der Umwandlungtemperatur bei paramagnetischen Eigenschaften eine zuvor eingeprägte Gedächtnisgestalt annimmt sowie
e) ein elektromechanischer Wandler als Einrichtung zur Generierung von elektrischer Energie aus dem wiederkehrenden Wechsel zwischen zwei Schaltstellungen vorgesehen ist.

2. Nichtresonanter thermomechanischer Energiewandler nach Anspruch 1, **dadurch gekennzeichnet, dass** der elektromechanische Wandler eine Induktionsspule umfasst und das Stellglied, das Stellelement oder eine andere Komponente des Energiewandlers nur in der zweiten Schaltstellung in das Feld der Induktionsspule einragt.

3. Nichtresonanter thermomechanischer Energiewandler nach Anspruch 2, **dadurch gekennzeichnet, dass** die Induktionsspule des Elektromagneten **(6)** durch einen mit einer Spule oder einen Permanentmagneten erregten Magnetkreis mit einer Unterbrechung gebildet wird und das Stellglied, das Stellelement oder eine andere Komponente des Energiewandlers in zweiter Schaltstellung in die Unterbrechung einragt.

4. Nichtresonanter thermomechanischer Energiewandler nach Anspruch 2 oder 3, **dadurch gekennzeichnet, dass** die Induktionsspule auf dem Stellglied in einem magnetischen Feld bewegbar angeordnet ist.

5. Nichtresonanter thermomechanischer Energiewandler nach Anspruch 1, **dadurch gekennzeichnet, dass** der elektromechanische Wandler eine pyroelektrische Komponente auf dem Stellglied oder dem Stellelement umfasst.

6. Nichtresonanter thermomechanischer Energiewandler nach einem der vorgenannten Ansprüche, **dadurch gekennzeichnet, dass** das Stellglied durch einen Doppelbalken gebildet wird, wobei die elektrische Kontaktierung des elektromechanischen Wandlers über den Doppelbalken erfolgt.

7. Nichtresonanter thermomechanischer Energiewandler nach einem der vorgenannten Ansprüche, **dadurch gekennzeichnet, dass** das Stellelement **(2)** aus einem magnetischen Material besteht und in der ersten Schaltstellung am Permanentmagneten **(4)** anliegt.

8. Nichtresonanter thermomechanischer Energiewandler nach einem der vorgenannten Ansprüche, **dadurch gekennzeichnet, dass** das Stellelement **(2)** integraler Bestandteil des Stellglieds **(1)** ist.

9. Nichtresonanter thermomechanischer Energiewandler einem der vorgenannten Ansprüche, **dadurch gekennzeichnet, dass** die Formgedächtnislegierung aus 50 - 54 At% Ni, 23 - 25 At% Mn und 21 - 25 At% Ga besteht.

10. Nichtresonanter thermomechanischer Energiewandler nach einem der vorgenannten Ansprüche, **dadurch gekennzeichnet, dass** das Stellglied **(1)** aus einem Balken mit zwei Enden oder einem kreuzblechförmiges Torsionselement besteht und in der ersten Schaltstellung flächig auf dem Heizelement **(5)** anliegt.

11. Nichtresonanter thermomechanischer Energiewandler nach Anspruch 10, **dadurch gekennzeichnet, dass** der Balken an einem Ende fest eingespannt ist und das Stellelement an einem anderen Ende des Balkens befestigt ist oder der Balken an beiden Ende fest eingespannt ist und das Stellelement mittig zwischen den beiden Enden auf dem Balken befestigt ist.

12. Nichtresonanter thermomechanischer Energiewandler nach einem der vorgenannten Ansprüche, **dadurch gekennzeichnet, dass** die Mittel nur durch das Zusammenwirken von Stellglied **(1)** und Permanentmagnet **(4)** sowie von Stellglied **(1)** und Heizlelement **(5)** und Kühlmittel gebildet werden.

13. Nichtresonanter thermomechanischer Energiewandler nach einem der vorgenannten Ansprüche, **dadurch gekennzeichnet, dass** das Heizelement eine Temperaturreglung aufweist.

14. Nichtresonanter thermomechanischer Energiewandler nach einem der vorgenannten Ansprüche, **dadurch gekennzeichnet, dass** das Stellglied nur in der zweiten Schaltstellung thermisch mit einem Kühlelement verbunden ist.

15. Nichtresonanter thermomechanischer Energiewandler nach Anspruch 14, **dadurch gekennzeichnet, dass** das Kühlelement nachgiebig ist.

## Claims

1. Non-resonant thermo-mechanical energy converter, **characterised in that**
a) an actuator (1) made of a shape-memory alloy with an actuating element (2) is provided, wherein the shape-memory alloy exhibits a Curie temperature and a conversion temperature from a martensitic to an austenitic phase,
b) means provided for a recurrent change between two switching positions of the actuator, wherein
c) the shape-memory alloy, in a first switching position below the Curie temperature and the conversion temperature, exhibits both ferromagnetic as well as martensitic properties, and the actuator, with a permanent magnet (4) and with a heating element (5) overcomes a magnetic or, respectively, a thermal reciprocal effect only in the first switching position,
d) the shape-memory alloy, in a second switching position, above the Curie temperature and the conversion temperature, with paramagnetic properties, adopts a previously determined memory shape, and
e) an electromagnetic converter is provided as a device for generating electrical energy from the recurrent change between two switching positions:

2. Non-resonant thermo-mechanical energy converter according to claim 1, **characterised in that** the electromagnetic converter comprises an induction coil, and the actuator or another component of the energy converter projects into the field of the induction coil only in the second switching position.

3. Non-resonant thermo-mechanical energy converter according to claim 2, **characterised in that** the induction coil of the electromagnet (6) is formed by a magnetic circuit, excited by a coil or a permanent magnet, with a break, and in the second switching position the actuator, the actuating element, or another component of the energy converter, projects into the break.

4. Non-resonant thermo-mechanical energy converter according to claim 2 or 3, **characterised in that** the induction coil is arranged such as to be moveable on the actuator in a magnetic field.

5. Non-resonant thermo-mechanical energy converter according to claim 1, **characterised in that** the electromagnetic converter comprises a pyroelectric component on the actuator or the actuating element.

6. Non-resonant thermo-mechanical energy converter according to any one of the preceding claims, **characterised in that** the actuator is formed by a double beam, wherein the electrical contacting of the electromechanical converter takes place via the double beam.

7. Non-resonant thermo-mechanical energy converter according to any one of the preceding claims, **characterised in that** the actuating element (2) consists of a magnetic material, which in the first switching position is in contact with the permanent magnet (4).

8. Non-resonant thermo-mechanical energy converter according to any one of the preceding claims, **characterised in that** the actuating element (2) is an integral component part of the actuator (1).

9. Non-resonant thermo-mechanical energy converter according to any one of the preceding claims, **characterised in that** the shape-memory alloy consists of 50-54 At% Ni, 23-25 At% Mn, and 21-25 At% Ga.

10. Non-resonant thermo-mechanical energy converter according to any one of the preceding claims, **characterised in that** the actuator (1) consists of a beam with two ends or a cruciform sheet metal torsion element which, in the first switching position, is in full surface contact with the heating element (5).

11. Non-resonant thermo-mechanical energy converter according to any one of the preceding claims, **characterised in that** the beam is securely tensioned at one end, and the actuating element is secured at another end of the beam, or the beam is securely tensioned at both ends, and the actuating element is secured in the middle between the two ends of the beam.

12. Non-resonant thermo-mechanical energy converter according to any one of the preceding claims, **characterised in that** the means are formed only by the interaction of the actuator (1) and the permanent magnet (4), as well as the actuator (1) and heating element (5) and cooling means.

13. Non-resonant thermo-mechanical energy converter according to any one of the preceding claims, **characterised in that** the heating element comprises temperature regulation.

14. Non-resonant thermo-mechanical energy converter according to any one of the preceding claims, **characterised in that** the actuator is thermally connected to a cooling element only when in the second switching position.

15. Non-resonant thermo-mechanical energy converter according to claim 14, **characterised in that** the cooling element is flexible.

## Revendications

1. Convertisseur d'énergie thermomécanique non résonant,
**caractérisé en ce que**
a) un organe de réglage (1) en un alliage à mémoire de forme est équipé d'un élément de réglage (2), cet alliage à mémoire de forme ayant une température de Curie et une température de conversion d'une phase martensitique en une phase austénitique,
b) il est prévu des moyens permettant un changement récurrent entre deux positions de commutation de l'organe de réglage,
c) dans la première position de commutation, dans laquelle il est au-dessous de la température de Curie et de la température de conversion, l'alliage à mémoire de forme ayant, des propriétés ferromagnétiques et également martensitiques, et l'organe de réglage ne surmontant une interaction magnétique ou thermique avec un aimant permanent (4) ou avec un élément de chauffage (5) que dans la première position de commutation,
d) dans la seconde position de commutation dans laquelle il est au-dessus de la température de Curie et de la température de conversion, l'alliage à mémoire de forme prend, du fait de propriétés paramagnétiques, une configuration d'effet mémoire auparavant inculquée, et
e) un convertisseur électromagnétique est prévu en tant que dispositif générateur d'énergie électrique à partir du changement récurrent entre les deux positions de commutation.

2. Convertisseur d'énergie thermomécanique non résonant conforme à la revendication 1,
**caractérisé en ce que**
le convertisseur électromécanique comprend une bobine d'induction et l'organe de réglage, l'élément de réglage ou un autre composant du convertisseur d'énergie n'entrent dans le champ de la bobine d'induction que dans la seconde position de commutation.

3. Commutateur d'énergie thermomécanique non résonnant conforme à la revendication 2,
**caractérisé en ce que**
la bobine d'induction de l'électroaimant (6) est formée par un circuit magnétique excité avec une bobine ou un aimant permanent, ayant une ouverture et l'organe de réglage, l'élément de réglage ou un autre composant du convertisseur d'énergie n'entre dans l'ouverture que dans la seconde position de commutation.

4. Convertisseur d'énergie thermomécanique non résonant conforme à la revendication 2 ou 3,
**caractérisé en ce que**
la bobine d'induction est montée mobile dans un champ magnétique sur l'organe de réglage.

5. Convertisseur d'énergie thermomécanique non résonant conforme à la revendication 1,
**caractérisé en ce que**
le convertisseur électromécanique comprend un composant pyro-électrique sur l'organe de réglage ou l'élément de réglage.

6. Convertisseur d'énergie thermomécanique non résonant conforme à l'une des revendications précédentes,
**caractérisé en ce que**
l'organe de réglage est formé par une double barre, la mise en contact électrique du convertisseur électromécanique étant effectuée par l'intermédiaire de cette double barre.

7. Convertisseur d'énergie thermomécanique non résonant conforme à l'une des revendications précédentes,
**caractérisé en ce que**
l'élément de réglage (2) est réalisé en un matériau magnétique et s'applique sur l'aimant permanent (4) dans la première position de commutation.

8. Convertisseur d'énergie thermomécanique non résonant conforme à l'une des revendications précédentes,
**caractérisé en ce que**
l'élément de réglage (2) fait partie intégrante de l'organe de réglage (1).

9. Convertisseur d'énergie thermomécanique non résonant conforme à l'une des revendications précédentes,
**caractérisé en ce que**
l'alliage à mémoire de forme est constitué de 50 à 54 At% de Ni, 23-25 At% de Mn et de 21-25 At% de Ga.

10. Convertisseur d'énergie thermomécanique non résonant conforme à l'une des revendications précédentes,
**caractérisé en ce que**
l'organe de réglage (1) est constitué par une barre ayant deux extrémités ou par un élément de torsion en forme de tôle transversal et s'applique à plat sur l'élément chauffant (5) dans la première position de commutation.

11. Convertisseur d'énergie thermomécanique non résonant conforme à la revendication 10,
**caractérisé en ce que**
la barre est serrée fermement à l'une de ses extrémités et l'élément de réglage est fixé à l'autre extrémité de la poutre, ou la poutre est serrée fermement à ses deux extrémités et l'élément de réglage est fixé dans une position médiane entre les deux extrémités sur la poutre.

12. Convertisseur d'énergie thermomécanique non résonant conforme à l'une des revendications précédentes,
**caractérisé en ce que**
les moyens permettant un changement récurrent ne sont formés que par la coopération de l'organe de réglage (2) et de l'aimant permanent (4) ainsi que de l'organe de réglage (1) et de l'élément chauffant (5) et des moyens de refroidissement.

13. Convertisseur d'énergie thermomécanique non résonant conforme à l'une des revendications précédentes,
**caractérisé en ce que**
l'élément chauffant comprend un réglage de la température.

14. Convertisseur d'énergie thermomécanique non résonant conforme à l'une des revendications précédentes,
**caractérisé en ce que**
l'organe de réglage n'est relié thermiquement à un élément de refroidissement que dans la seconde position de commutation.

15. Convertisseur d'énergie thermomécanique non résonant conforme à la revendication 14,
**caractérisé en ce que**
l'élément de refroidissement est déformable.
